(19) Europäisches Patentamt
European Patent Office
Office européen des brevets

(11) **EP 3 749 077 B1**

(12) **EUROPEAN PATENT SPECIFICATION**

(45) Date of publication and mention
of the grant of the patent:
**20.11.2024 Bulletin 2024/47**

(21) Application number: **19815440.3**

(22) Date of filing: **05.06.2019**

(51) International Patent Classification (IPC):
***H05K 9/00*** *(2006.01)*      ***B32B 7/025*** *(2019.01)*
***H01Q 17/00*** *(2006.01)*

(52) Cooperative Patent Classification (CPC):
**H05K 9/0088; B32B 7/025; H01Q 17/00;**
**H05K 9/00; H05K 9/0094**

(86) International application number:
**PCT/JP2019/022373**

(87) International publication number:
**WO 2019/235536 (12.12.2019 Gazette 2019/50)**

(54) **ELECTROMAGNETIC WAVE ABSORPTION SHEET**

ABSORPTIONSSCHICHT FÜR ELEKTROMAGNETISCHE WELLEN

FEUILLE D'ABSORPTION D'ONDES ÉLECTROMAGNÉTIQUES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.06.2018 JP 2018109623**

(43) Date of publication of application:
**09.12.2020 Bulletin 2020/50**

(73) Proprietor: **Maxell, Ltd.**
**Kyoto 618-8525 (JP)**

(72) Inventor: **TOYODA Masayuki**
**Kyoto 618-8525 (JP)**

(74) Representative: **Diehl & Partner**
**Patent- und Rechtsanwaltskanzlei mbB**
**Erika-Mann-Straße 9**
**80636 München (DE)**

(56) References cited:
**EP-A1- 3 595 422          EP-A1- 3 684 155**
**WO-A1-2018/088492      WO-A1-2018/088492**
**JP-A- 2006 086 446      JP-A- 2008 124 154**
**JP-A- 2008 124 154      JP-A- 2008 135 485**
**JP-A- 2008 135 485      JP-A- 2009 084 400**
**JP-A- 2009 084 400      JP-A- 2011 066 094**
**JP-A- 2011 066 094      JP-A- 2018 117 073**
**US-A1- 2010 097 048    US-A1- 2015 305 144**
**US-B1- 6 486 394**

**Description**

Technical Field

The present disclosure relates to an electromagnetic-wave absorbing sheet having flexibility, in particular, an electromagnetic-wave absorbing sheet that can absorb electromagnetic waves in a millimeter-wave band from several tens of gigahertz (GHz) to several hundreds gigahertz (GHz) or electromagnetic waves in a still higher frequency band.

Background Art

Electromagnetic-wave absorbing sheets for absorbing electromagnetic waves have been used to avoid influences of leaked electromagnetic waves to be emitted to the outside from electric circuits and influences of undesirably reflected electromagnetic waves.

Recently, researches on technologies of utilizing high frequency electromagnetic waves, including centimeter waves having a frequency of several gigahertz (GHz), millimeter waves having a frequency of 30 GHz to 300 GHz, and electromagnetic waves having a still higher frequency of one terahertz (THz) as electromagnetic waves in a high frequency band above the millimeter-wave band, have proceeded for mobile communications such as mobile phones, wireless LAN and electric toll collection system (ETC).

There will be a growing demand, in response to such a technical trend of utilizing electromagnetic waves of high frequencies, that electromagnetic-wave absorbers for absorbing unnecessary electromagnetic waves and electromagnetic-wave absorbing sheets, which are sheet-shaped electromagnetic-wave absorbers that provide higher user convenience, can absorb electromagnetic waves in a frequency band equal to or higher than the millimeter-wave band.

As such electromagnetic-wave absorbing sheets, electromagnetic-wave absorbing sheets of an electromagnetic-wave interference type ($\lambda/4$ type, also referred to as reflection-type) are known. In the electromagnetic-wave absorbing sheets of an electromagnetic-wave interference type, an electric resistance film is formed on one surface of a dielectric layer, and an electromagnetic-wave shielding layer that reflects electromagnetic waves is formed on the other surface of the dielectric layer. Electromagnetic waves are absorbed by shifting the phase of reflected waves with respect to the phase of incident waves incident upon the electromagnetic-wave absorbing sheet by 1/2 wavelength to make the incident waves and the reflected waves cancel each other out. The electromagnetic-wave absorbing sheets of an electromagnetic-wave interference type can be produced easily and are lightweight as compared with electromagnetic-wave absorbing sheets magnetically absorbing electromagnetic waves by magnetic particles with large specific gravity, and thus are advantageous in cost reduction.

Conventionally, it is known that in the electromagnetic-wave absorbing sheets (electromagnetic-wave absorbers) of an electromagnetic-wave interference type, the electric resistance film on one surface of the dielectric layer is formed by ion plating, vacuum evaporation, sputtering or the like, using metal oxide such as indium tin oxide (ITO), indium oxide, stannic oxide or zinc oxide, metal nitride, or a mixture of these (see Patent Document 1, Patent Document 2).

Further, Patent Document 3 proposes an electromagnetic-wave absorber of an electromagnetic-wave interference type having flame resistance and light transmittance, which includes a resistance layer made of a transparent conductive material such as indium tin oxide (ITO) film, a transparent dielectric layer made of glass, acrylic resin or the like, and a reflective film made of metal such as silver, gold, copper or aluminum that is formed on the dielectric layer.

Patent document 4 discloses a flexible electromagnetic-wave absorbing sheet formed by sequentially laminating a resistance film, a dielectric layer, and an electromagnetic-wave shielding layer, wherein the resistance film is formed of a conductive organic polymer.

Prior Art Documents

Patent Documents

Patent Document 1: JP H06(1994)-120689 A
Patent Document 2: JP H09(1997)-232787 A
Patent Document 3: JP 2006-086446 A
Patent Document 4: WO 2018/088492 A1

Disclosure of Invention

Problem to be Solved by the Invention

In the conventional electromagnetic-wave absorbing sheets and electromagnetic-wave absorbers, impedance matching is performed in which the sheet resistance of the electric resistance film formed on the surface of the dielectric layer is set to be close to 377 $\Omega$/sq, thereby preventing the deterioration of electromagnetic-wave absorbing effects due to reflection or scattering of electromagnetic waves on the surfaces of the absorbing sheets.

On the other hand, in the electromagnetic-wave absorbing sheets of an electromagnetic-wave interference type, since the dielectric layer is thinned as the frequency of electromagnetic waves to be absorbed increases, the sheets can have high flexibility. The thin and bendable electromagnetic-wave absorbing sheets can be attached to various places and improve the convenience of users, but they are more likely to be bent strongly by users. At this time, the electric resistance film formed by sputtering or the like using metal oxide cracks easily by being bent strongly, and the surface electric resistance increases. This collapses impedance matching and deteriorates the electromagnetic-wave absorbing properties.

Moreover, electromagnetic-wave absorbing sheets having light transmittance and flexibility have not been realized conventionally.

It is an object of the present disclosure to provide an electromagnetic-wave absorbing sheet of an electromagnetic-wave interference type that solves the above conventional problems, can favorably absorb electromagnetic waves in a frequency band equal to or higher than the millimeter-wave band, and can be produced at low cost.

Means for Solving Problem

In order to solve the above problems, an electromagnetic-wave absorbing sheet disclosed in this application is an electromagnetic-wave absorbing sheet of an electromagnetic-wave interference type according to claim 1.

Effects of the Invention

Since the electric resistance film of the electromagnetic-wave absorbing sheet disclosed in this application is formed of a conductive organic polymer, the electromagnetic-wave absorbing sheet can maintain impedance matching and keep high electromagnetic-wave absorbing properties even when the sheet is strongly bent. Moreover, since the dielectric layer itself has adhesiveness, the electric resistance film and the electromagnetic-wave shielding layer can easily adhere to the dielectric layer. Thus, it is possible to constitute an electromagnetic-wave absorbing sheet that can absorb electromagnetic waves in a frequency band equal to or higher than the millimeter-wave band, has flexibility, and is highly convenient, at low cost.

Brief Description of Drawings

[FIG. 1] FIG. 1 is a cross-sectional view illustrating the configuration of an electromagnetic-wave absorbing sheet of this embodiment.
[FIG. 2] FIG. 2 is a model figure illustrating the shape of the electromagnetic-wave shielding layer used for examining an aperture ratio.

Description of the Invention

An electromagnetic-wave absorbing sheet disclosed in this application is an electromagnetic-wave absorbing sheet of an electromagnetic-wave interference type, including an electric resistance film formed of a conductive organic polymer, a dielectric layer having adhesiveness, and an electromagnetic-wave shielding layer that are sequentially stacked. The sheet as a whole has flexibility. A thickness of the dielectric layer is set so that the dielectric layer can absorb electromagnetic waves in a frequency band equal to or higher than the millimeter-wave band.

In the present invention, "dielectric layer has adhesiveness" means that the dielectric layer itself has adhesiveness, and thus can be united with the stacked electric resistance film and electromagnetic-wave shielding layer without additionally forming an adhesive layer. Moreover, the "dielectric layer having adhesiveness" can be constituted by using a material having adhesiveness as a material constituting a dielectric layer (e.g., acrylic resin, urethane resin, polyethylene resin) or by adding an adhesive such as a silicone-based adhesive, an acrylic-based adhesive, or a urethane-based adhesive to a dielectric layer to impart adhesiveness to the dielectric layer.

By doing so, the electromagnetic-wave absorbing sheet disclosed in this application, which is an electromagnetic-wave absorbing sheet of an electromagnetic-wave interference type in which an electric resistance film, a dielectric layer, and an electromagnetic-wave shielding layer are stacked, is less likely to have cracks on the electric resistance film even when the sheet is bent strongly, thereby maintaining the impedance matching and exhibiting high electromagnetic-wave absorbing properties. Moreover, since the dielectric layer itself has adhesiveness, the dielectric layer and the electric resistance film as well as the dielectric layer and the electromagnetic-wave shielding layer can easily adhere to each other. Therefore, it is possible to constitute an electromagnetic-wave absorbing sheet that has flexibility as a whole and can absorb electromagnetic waves in a frequency band equal to or higher than the millimeter-wave band, at low cost.

It is preferable that in the electromagnetic-wave absorbing sheet disclosed in this application, both of the electric resistance film and the dielectric layer have light transmittance, the electromagnetic-wave shielding layer is constituted by a conductive mesh, and the sheet as a whole has light transmittance having a total light transmittance of 30% or more. By doing so, higher convenience is imparted to the electromagnetic-wave absorbing sheet as an electromagnetic-wave absorbing sheet having light transmittance.

Moreover, it is preferable that the dielectric layer contains at least one adhesive selected from a silicone-based adhesive, an acrylic-based adhesive, and a urethane-based adhesive. All of these adhesives are OCA (Optically Clear Adhesive) materials having high light transmittance, and, while the electric resistance film and the electromagnetic-wave shielding layer can favorably adhere to the dielectric layer, high optical characteristics of the sheet as a whole can be achieved.

Moreover, it is preferable that the electromagnetic-wave shielding layer has a surface electric resistance of 0.3 $\Omega$/sq or less. Further, it is preferable that the electromagnetic-wave shielding layer has an aperture ratio of 35% to 85%. By doing so, it is possible to obtain an electromagnetic-wave shielding layer that achieves high electromagnetic-wave absorbing properties while having light transmittance.

Moreover, it is preferable that the electric resistance film includes poly(3,4-ethylenedioxythiophene). By doing so, it is possible to constitute an electromagnetic-wave absorbing sheet maintaining the impedance matching and exhibiting high electromagnetic-wave absorbing properties even when the sheet as a whole is strongly bent.

Moreover, the electromagnetic-wave absorbing sheet can further include an adhesive layer on a surface of the electromagnetic-wave shielding layer on a side opposite to a side where the dielectric layer is disposed. By doing so, the electromagnetic-wave absorbing sheet can easily be attached to a desired position, whereby convenience is further improved.

Hereinafter, the electromagnetic-wave absorbing sheet disclosed in this application will be described with reference to the drawings. The following embodiment exemplifies an electromagnetic-wave absorbing sheet that has light transmittance while having flexibility as a whole.

(Embodiment)

First, the overall configuration of an electromagnetic-wave absorbing sheet of this embodiment will be described.

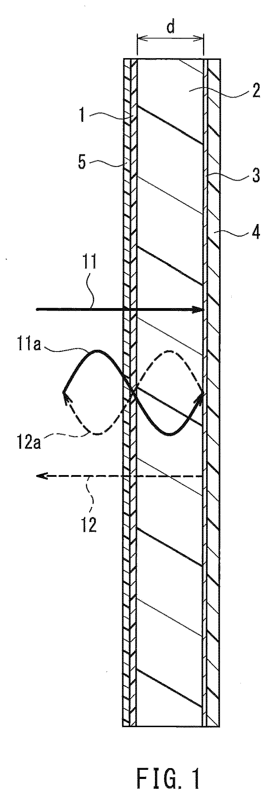

FIG. 1 is a cross-sectional view illustrating the configuration of the electromagnetic-wave absorbing sheet of this embodiment.

FIG. 1 is illustrated for the sake of easy understanding of the configuration of the electromagnetic-wave absorbing sheet of this embodiment, and does not faithfully reflect the actual sizes or thicknesses of members illustrated therein.

The electromagnetic-wave absorbing sheet exemplified in this embodiment is an electromagnetic-wave absorbing sheet of an electromagnetic-wave interference type ($\lambda$/4 type, reflection-type), and is formed by stacking an electric resistance film 1, a dielectric layer 2, and an electromagnetic-wave shielding layer 3. In the electromagnetic-wave absorbing sheet illustrated in FIG. 1, an adhesive layer 4 is stacked on a surface of the electromagnetic-wave shielding layer 3 on a back side, i.e., a side in the electromagnetic-wave shielding layer 3 opposite to a side where the dielectric layer 2 is disposed. A protective layer 5 is stacked on a surface of the electric resistance film 1 on a front side, i.e., a side in the electric resistance film 1 opposite to a side where the dielectric layer 2 is disposed.

In the electromagnetic-wave absorbing sheet of this embodiment, electromagnetic waves 11 incident upon the dielectric layer 2 are reflected at an interface between the dielectric layer 2 and the electromagnetic-wave shielding layer 3 that is disposed on the back side of the dielectric layer 2, and emitted to the outside as reflected waves 12. By adjusting a thickness d of the dielectric layer 2 to 114 of a wavelength $\lambda$ of incident electromagnetic waves (d = $\lambda$/4), a phase 11a of the incident waves 11 and a phase 12a of the reflected waves 12 are canceled each other out, whereby electromagnetic waves incident upon the electromagnetic-wave absorbing sheet are absorbed.

The above formula d = $\lambda$/4 is established when the dielectric layer 2 is air (permittivity $\varepsilon$ = 1). When the dielectric layer 2 is a dielectric having permittivity $\varepsilon_r$, a formula $d = \lambda/(4\sqrt{\varepsilon_r})$ is established, and the thickness d of the dielectric layer 2 can be reduced by $d = 1/(4\sqrt{\varepsilon_r})$ . Such a reduction in the thickness of the dielectric layer 2 can reduce the thickness of the electromagnetic-wave absorbing sheet as a whole, whereby it is possible to constitute an electromagnetic-wave absorbing sheet having still higher flexibility.

Moreover, in the electromagnetic-wave absorbing sheet of this embodiment, the dielectric layer 2 has adhesiveness. The dielectric layer 2 may be an organic material having adhesiveness such as a resin or an adhesive.

The electromagnetic-wave shielding layer 3, which is stacked on the back side of the dielectric layer 2, reflects incident electromagnetic waves on the surface on the dielectric layer 2 side, i.e., the boundary surface with the dielectric layer 2.

From the principle of electromagnetic-wave absorption in the electromagnetic-wave absorbing sheet of an electromagnetic-wave interference type of this embodiment, it is necessary that the electromagnetic-wave shielding layer 3 functions as a reflective layer that reflects electromagnetic waves. Moreover, in order for the electromagnetic-wave absorbing sheet of this embodiment to have flexibility and light transmittance, it is also necessary that the electromagnetic-wave shielding layer has flexibility and light transmittance. The electromagnetic-wave shielding layer 3 that satisfies such a demand may be a conductive mesh constituted by conductive fibers, or a conductive grid constituted by conductive wires such as super fine metal wires.

In the electromagnetic-wave absorbing sheet of this embodiment, when the dielectric layer 2 and the electromagnetic-wave shielding layer 3 are arranged in contact with each other the electromagnetic-wave shielding layer 3 and the dielectric layer 2 can be in a state of being in close contact with each other by the adhesiveness of the dielectric layer 2. The electric resistance film 1 is formed on a front side of the dielectric layer 2, i.e., a side of the dielectric layer 2 from which electromagnetic waves to be absorbed enter, which is opposite to the side where the electromagnetic-wave shielding layer 3 is stacked. The electric resistance film 1 matches impedances between the electromagnetic-wave absorbing sheet and air.

By setting the input impedance of the electromagnetic-wave absorbing sheet to be close to the impedance in the air of 377 Ω (vacuum impedance in practice) when electromagnetic waves propagating through the air enter the electromagnetic-wave absorbing sheet, it is possible to prevent the deterioration of electromagnetic-wave absorbing properties due to reflection or scattering of electromagnetic waves when entering the sheet. In the electromagnetic-wave absorbing sheet of this embodiment, by forming the electric resistance film 1 as a conductive organic polymer film, the electromagnetic-wave absorbing sheet can have flexibility while the electric resistance film 1 does not crack even when the electromagnetic-wave absorbing sheet is strongly bent. Thereby, the surface electric resistance does not change, and favorable impedance matching can be maintained.

The adhesive layer 4 formed on the back side of the electromagnetic-wave shielding layer 3 makes the electromagnetic-wave absorbing sheet easily attachable to a predetermined position. The adhesive layer 4 can be formed easily by application of an adhesive resin paste.

The adhesive layer 4 is not an essential member in the electromagnetic-wave absorbing sheet of this embodiment. In an arrangement of the electromagnetic-wave absorbing sheet to a predetermined position, a member for adhesion may be arranged on a member on which the electromagnetic-wave absorbing sheet is to be attached, or an adhesive may be supplied or a double-sided tape may be used between the electromagnetic-wave absorbing sheet and an arrangement position.

The protective layer 5 is formed on a front surface of the electric resistance film 1, i.e., an uppermost surface in the electromagnetic-wave absorbing sheet on the electromagnetic-wave incident side, to protect the electric resistance film 1.

The moisture in the air may change the surface electric resistance of the conductive organic polymer constituting the electric resistance film 1 of the electromagnetic-wave absorbing sheet of this embodiment. Further, since the electric resistance film 1 is made of resin, it may be damaged when a sharp member contacts the surface, or a hard material rubs against the surface. To avoid this, it is preferable to protect the electric resistance film 1 by covering the surface of the electric resistance film 1 with the protective layer 5.

The protective layer 5 is not an essential member in the electromagnetic-wave absorbing sheet of this embodiment. Depending on the material of the conductive organic polymer, there is little concern about the change in the surface electric resistance due to the moisture attached to the surface or the damage of the surface of the electric resistance film 1. In this case, the electromagnetic-wave absorbing sheet can be configured without the protective layer 5.

The protective layer 5 may be made of a resin material such as polyethylene terephthalate as described later. Although the resin material used as the protective layer 5 has a certain resistance, the influence of the resistance of the protective layer 5 on the surface electric resistance of the electromagnetic-wave absorbing sheet can be reduced to a level having no problem in practical use in performing the impedance matching by setting the thickness of the protective layer 5 thin.

Next, members constituting the electromagnetic-wave absorbing sheet of this embodiment will be described in detail.

[Electric resistance film]

In the electromagnetic-wave absorbing sheet of this embodiment, the electric resistance film 1 is formed of a conductive organic polymer.

As the conductive organic polymer, a conjugated conductive organic polymer is used, and preferable examples of which include polythiophene and derivatives thereof, and polypyrrole and derivatives thereof.

Specific examples of the polythiophene-based conductive polymer suitably used for the electric resistance film 1 of the electromagnetic-wave absorbing sheet of this embodiment include poly(thiophene), poly(3-methylthiophene), poly(3-ethylthiophene), poly(3-propylthiophene), poly(3-butylthiophene), poly(3-hexylthiophene), poly(3-heptylthiophene), poly(3-octylthiophene), poly(3-decylthiophene), poly(3-dodecylthiophene), poly(3-octadecylthiophene), poly(3-bromothiophene), poly(3-chlorothiophene), poly(3-iodothiophene), poly(3-cyanothiophene), poly(3-phenylthiophene), poly(3,4-dimethylthiophene), poly(3,4-dibutylthiophene), poly(3-hydroxythiophene), poly(3-methoxythiophene), poly(3-ethoxythiophene), poly(3-butoxythiophene), poly(3-hexyloxythiophene), poly(3-heptyloxythiophene), poly(3-octyloxythiophene), poly(3-decyloxythiophene), poly(3-dodecyloxythiophene), poly(3-octadecyloxythiophene), poly(3,4-dihydroxythiophene), poly(3,4-dimethoxythiophene), poly(3,4-diethoxythiophene), poly(3,4-dipropoxythiophene), poly(3,4-dibutoxythiophene), poly(3,4-dihexyloxythiophene), poly(3,4-diheptyloxythiophene), poly(3,4-dioctyloxythiophene), poly(3,4-didecyloxythiophene), poly(3,4-didodecyloxythiophene), poly(3,4-ethylenedioxythiophene), poly(3,4-propylenedioxythiophene), poly(3,4-butenedioxythiophene), poly(3-methyl-4-methoxythiophene), poly(3-methyl-4-ethoxythiophene), poly(3-carboxythiophene), poly(3-methyl-4-carboxythiophene), poly(3-methyl-4-carboxyethylthiophene), and poly(3-methyl-4-carboxybutylthiophene).

Specific examples of the polypyrrole-based conductive polymer suitably used for the electric resistance film 1 include polypyrrole, poly(N-methylpyrrole), poly(3-methylpyrrole), poly(3-ethylpyrrole), poly(3-n-propylpyrrole), poly(3-butylpyrrole), poly(3-octylpyrrole), poly(3-decylpyrrole), poly(3-dodecylpyrrole), poly(3,4-dimethylpyrrole), poly(3,4-dibutylpyrrole), poly(3-carboxypyrrole), poly(3-methyl-4-carboxypyrrole), poly(3-methyl-4-carboxyethylpyrrole), poly(3-methyl-4-carboxybutylpyrrole), poly(3-hydroxypyrrole), poly(3-methoxypyrrole), poly(3-ethoxypyrrole), poly(3-butoxypyrrole), poly(3-hexyloxypyrrole), poly(3-methyl-4-hexyloxypyrrole), and poly(3-methyl-4-hexyloxypyrrole).

In addition, an organic polymer whose main chain is composed of a $\pi$ conjugated system may be used as the electric resistance film 1. Examples of such an organic polymer include polyacetylene-based conductive polymers, polyphenylene-based conductive polymers, polyphenylene vinylene-based conductive polymers, polyaniline-based conductive polymers, polyacene-based conductive polymers, polythiophene vinylene-based conductive polymers, and copolymers of these.

As the conductive organic polymer used for the electric resistance film, polyanion may be used as a counter anion. Although not particularly limited, it is preferred that the polyanion contains an anion group that enables the conjugated conductive organic polymer used for the electric resistance film to cause chemical oxidation doping. Examples of such an anion group include groups expressed by general formulae -O-SO$_3$X, -O-PO(OX)$_2$, -COOX, and -SOsX (in each formula, X represents a hydrogen atom or an alkali metal atom). Among them, the groups expressed by -SO$_3$X and -O-SOsX are particularly preferred because of their excellent doping effects on the conjugated conductive organic polymer.

Specific examples of the polyanion include: polymers having a sulfonic group such as polystyrene sulfonic acid, polyvinyl sulfonic acid, polyallyl sulfonic acid, polyacryl sulfonic acid, polymethacryl sulfonic acid, poly(2-acrylamide-2-methylpropanesulfonic acid), polyisoprene sulfonic acid, polysulfoethyl methacrylate, poly(4-sulfobutyl methacrylate), and polymethacryloxybenzene sulfonic acid; and polymers having a carboxylic group such as polyvinyl carboxylic acid, polystyrene carboxylic acid, polyallyl carboxylic acid, polyacryl carboxylic acid, polymethacryl carboxylic acid, poly(2-acrylamide-2-methylpropanecarboxylic acid), polyisoprene carboxylic acid, and polyacrylic acid. The polyanion may be a homopolymer of one of them or a copolymer of two or more of them. One of the polyanions may be used alone, or two or more of the polyanions may be used in combination. Among the polyanions, polymers having a sulfonic group are preferred, and polystyrene sulfonic acid is more preferred.

One of the conductive organic polymers may be used alone, or two or more of the conductive organic polymers may be used in combination. Among the materials exemplified above, polymers composed of one or two selected from polypyrrole, poly(3-methoxythiophene), poly(3,4-ethylenedioxythiophene), poly(2-aniline sulfonic acid), and poly(3-aniline sulfonic acid) are preferred from the viewpoint of enhancing light transmittance and conductivity.

Particularly, it is preferable to use poly(3,4-ethylenedioxythiophene: PEDOT) and polystyrene sulfonic acid (PSS) as a combination of the conjugated conductive organic polymer and the polyanion.

In the electric resistance film 1 of this embodiment, a dopant may be used in combination with the conductive organic polymer to control the electric conductivity of the conductive organic polymer and match the input impedance of the electromagnetic-wave absorbing sheet to the impedance in the air. Examples of the dopant include halogens such as iodine and chlorine, Lewis acids such as $BF_3$ and $PF_5$, proton acids such as nitric acid and sulfuric acid, transition metals, alkali metals, amino acids, nucleic acids, surfactants, pigments, chloranil, tetracyanoethylene, and TCNQ. More specifically, it is preferable to set the surface electric resistance of the electric resistance film 1 to about plus or minus several percent of 377 $\Omega$. The blending ratio between the conductive organic polymer and the dopant may be, e.g., conductive polymer : dopant = 1 : 2 to 1 : 4 in mass ratio.

It is preferred that the electric resistance film 1 further contains polyvinylidene fluoride.

Polyvinylidene fluoride functions as a binder in the conductive organic polymer film by being added to a composition for coating the conductive organic polymer, thereby improving film formability while enhancing the adherence to a base.

Moreover, it is preferred that the electric resistance film 1 further contains water-soluble polyester. Since the water-soluble polyester is highly compatible with the conductive polymer, it can fix the conductive polymer in the electric resistance film 1 by being added to the coating composition of the conductive organic polymer constituting the electric resistance film 1, thereby allowing the film to be more homogeneous. As a result of the use of the water-soluble polyester, the surface electric resistance is less likely to change even in more severe high temperature and high humidity environments, and it is possible to maintain a state in which the impedances between the electromagnetic-wave absorbing sheet and the air are matched.

Since the electric resistance film 1 including polyvinylidene fluoride and water-soluble polyester can have higher weather resistance, the change in the surface electric resistance of the electric resistance film 1 over time is reduced, and it is possible to constitute a highly reliable electromagnetic-wave absorbing sheet that can maintain stable electromagnetic-wave absorbing properties.

The content of the conductive organic polymer in the electric resistance film 1 is preferably 10 mass% or more and 35 mass% or less based on the total mass of the solid content in the composition of the electric resistance film 1. If the content of the conductive organic polymer is less than 10 mass%, the conductivity of the electric resistance film 1 tends to decrease. Therefore, it is difficult to match the impedances between the electromagnetic-wave absorbing sheet and the air, and electromagnetic-wave absorbency decreases. Moreover, if the surface electric resistance of the electric resistance film 1 is set within a predetermined range for impedance matching, the thickness of the electric resistance film 1 tends to increase, which increases the thickness of the electromagnetic-wave absorbing sheet as a whole and deteriorates optical characteristics such as light transmittance. Meanwhile, if the content of the conductive organic polymer exceeds 35 mass%, the coating appropriateness at the time of coating the electric resistance film 1 tends to decrease due to the structure of the conductive organic polymer, which makes it difficult to form a favorable electric resistance film 1, increases the haze of the electric resistance film 1, and deteriorates optical characteristics.

The electric resistance film 1 can be formed by applying the coating composition that is a coating material for forming the electric resistance film onto a base and drying it as described above.

The application method of the coating material for forming the electric resistance film onto a base may be, e.g., bar coating, reverse coating, gravure coating, smaller diameter gravure coating, die coating, dip coating, spin coating, slit coating, or spray coating. Drying after the application is not particularly limited as long as it is performed under the condition that allows a solvent component of the coating material for forming the electric resistance film to evaporate, but it is preferably performed at 100°C to 150°C for 5 to 60 minutes. If a solvent remains in the electric resistance film 1, the strength tends to deteriorate. The drying method may be, e.g., hot-air drying, heat drying, vacuum drying, or natural drying. The electric resistance film 1 may be formed by curing the coated film by irradiation with UV light (ultraviolet light) or EB (electron beams) as needed.

The base to be used for forming the electric resistance film 1 is not particularly limited, but it is preferably a transparent base having light transmittance. Various materials such as resin, rubber, glass, and ceramics can be used as the material of the transparent base.

By forming the electric resistance film 1 having a surface electric resistance of 377 $\Omega$/sq using the conductive organic polymer, the input impedance of the electromagnetic-wave absorbing sheet of this embodiment can be matched to the impedance in the air. Thereby, reflection or scattering of electromagnetic waves on the surface of the electromagnetic-wave absorbing sheet can be reduced, and more favorable electromagnetic-wave absorbing properties can be obtained.

[Dielectric layer]

As the dielectric layer 2 of the electromagnetic-wave absorbing sheet of this embodiment, an optically clear adhesive film (OCA film) that is a material having light transmittance and adhesiveness can be suitably used.

More specifically, MHM-SI-500 (trade name, manufactured by Nichiei Kakoh Co., Ltd.) that is a silicone-based OCA, MHM-FWV (trade name, manufactured by Nichiei Kakoh Co., Ltd.) that is an acrylic-based OCA, or Free Crystal (trade name, manufactured by Bando Chemical Industries, Ltd.) that is a urethane-based OCA may be used.

Among the above materials, the silicone-based OCA is more excellent than the other materials from the viewpoints of heat resistance and cold resistance. Therefore, an electromagnetic-wave absorbing sheet using the silicone-based OCA is a preferable material in that the sheet has fewer environmental temperature restrictions on locations to be used.

In the electromagnetic-wave absorbing sheet of this embodiment, by the dielectric layer 2 having adhesiveness, the electric resistance film 1 formed as a thin film made of a resin material and the dielectric layer 2 can adhere to each other when the electric resistance film 1 is stacked on the dielectric layer 2. This eliminates a step of attaching the electric resistance film 1 and the dielectric layer 2 to each other (e.g., a lamination step) that is necessary if the dielectric layer 2 does not have adhesiveness, thereby simplifying the production of the electromagnetic-wave absorbing sheet and reducing the production costs. The electric resistance film 1 and the dielectric layer 2 may be laminated as appropriate in a state of being stacked to make them more strongly adhere to each other.

Moreover, when a conductive mesh or a conductive grid material is used as the electromagnetic-wave shielding layer 3 in order to obtain an electromagnetic-wave absorbing sheet having light transmittance, the electromagnetic-wave shielding layer 3 can be disposed on the back side of the dielectric layer 2 in the state of being in intimate close contact with the dielectric layer by the adhesiveness of the dielectric layer 2. The adhesive strength of the dielectric layer 2 is preferably 8 to 35 N/25 mm as a measurement result by a 180° peel adhesion test method. If the adhesive strength is less than 8 N/25 mm, the dielectric layer 2 and the electromagnetic-wave shielding layer 3 are easily peeled off from each other. If the adhesive strength is more than 35 N/mm, the adhesion is too strong, and the reworkability at the time of rearrangement deteriorates, resulting in larger restrictions on the production of the electromagnetic-wave absorbing sheet.

The dielectric layer 2 may be a single layer made of one material, or a stack of two or more layers made of the same material or different materials. The formation method of the dielectric layer 2 may be, e.g., an application method, press molding, or extrusion molding.

As described above, the electromagnetic-wave absorbing sheet of this embodiment is an electromagnetic-wave absorbing sheet of an electromagnetic-wave interference type ($\lambda$/4 type) that absorbs electromagnetic waves by shifting, with respect to the phase of electromagnetic waves incident upon the electromagnetic-wave absorbing sheet, the phase of reflected waves reflected by the electromagnetic-wave shielding layer 3 by 1/2 wavelength to make the incident waves and the reflected waves cancel each other out. Therefore, the thickness of the dielectric layer (d in FIG. 1) is determined corresponding to the wavelength of electromagnetic waves to be absorbed.

The formula d = $\lambda$/4 is established when an interspace between the electric resistance film 1 and the electromagnetic-wave shielding layer 3 is a space, i.e., the dielectric layer 2 is constituted by air. When the dielectric layer 2 is formed of a material having permittivity $\varepsilon_r$, the thickness d is $d = \lambda/(4(\sqrt{\varepsilon_r}))$. By using as a material constituting the dielectric layer 2 a material having large permittivity, the thickness d of the dielectric layer 2 can be reduced by $1/\sqrt{\varepsilon_r}$, and the thickness of the electromagnetic-wave absorbing sheet as a whole can be reduced. In order for the electromagnetic-wave absorbing sheet of this embodiment to have flexibility, it is more preferred that the dielectric layer 2 constituting the electromagnetic-wave absorbing sheet and the electromagnetic-wave absorbing sheet itself are as thin as possible to make the sheet bent more easily. Further, considering that the electromagnetic-wave absorbing sheet of this embodiment is often to be attached via the adhesive layer 4 (described later) or the like to a member whose electromagnetic wave leakage is desired to be prevented, it is preferred that the electromagnetic-wave absorbing sheet is thin to easily conform to the shape of an attachment part and lightened further.

In this manner, in the electromagnetic-wave absorbing sheet of this embodiment, by adjusting the permittivity $\varepsilon_r$ of an dielectric used as the dielectric layer 2 and the thickness of the dielectric layer 2, it is possible to control the wavelength of electromagnetic waves in a high frequency band equal to or higher than the millimeter-wave band so that the electromagnetic waves can be absorbed by the electromagnetic-wave absorbing sheet including the dielectric layer 2. Moreover, by the dielectric layer 2 having adhesiveness, the electric resistance film 1 and the dielectric layer 2 as well as the electromagnetic-wave shielding layer 3 (described later) and the dielectric layer 2 can be disposed in close contact with each other. If there is a gap between the layers in the electromagnetic-wave absorbing sheet of an electromagnetic-wave interference type, the gap has permittivity. Therefore, the permittivity of the dielectric layer 2 deviates from a predetermined value. This results in fluctuation in the frequency of the electromagnetic waves to be absorbed. However, the dielectric layer of this embodiment having adhesiveness can favorably avoid such a disadvantage.

[Electromagnetic-wave shielding layer]

The electromagnetic-wave shielding layer 3 of the electromagnetic-wave absorbing sheet of this embodiment, which is disposed on the side in the electromagnetic-wave absorbing sheet opposite to the electromagnetic-wave incident side (i.e., a back side) via the dielectric layer 2, reflects electromagnetic waves that have entered and penetrated the electric resistance film 1.

In order for the electromagnetic-wave absorbing sheet of this embodiment to have flexibility and light transmittance, the electromagnetic-wave shielding layer 3 needs to have flexibility so that it bends to follow at least the electric resistance film 1 and the dielectric layer 2 while having light transmittance.

The electromagnetic-wave shielding layer 3 that satisfies such a demand may be a conductive mesh constituted by conductive fibers. In one example, the conductive mesh can be formed by depositing a metal on a mesh woven from polyester monofilaments to impart conductivity to the mesh. The metal may be highly conductive metal such as copper or silver. Further, in order to reduce reflection by the metal film covering the mesh surface, a product in which a black antireflective layer is further provided on the outer side of the metal film is also on the market.

In addition to the above, the electromagnetic-wave shielding layer 3 may be a conductive grid constituted by fine metal wires (e.g., copper wires) having a diameter of several tens to several hundreds pm, which are arranged horizontally and vertically.

In order to obtain flexibility and light transmittance, the thickness of the electromagnetic-wave shielding layer 3 constituted by the conductive mesh or conductive grid is set to minimal within a range in which the electromagnetic-wave shielding layer 3 can have a desired surface electric resistance. If the fibers of the conductive mesh or the wires of the conductive grid are damaged or cut, it becomes difficult to obtain a desired surface electric resistance. To avoid this, a reinforcing layer and a protective layer made of resin having light transmittance may be formed on the back side of the conductive grid so that the electromagnetic-wave shielding layer 3 is configured as a stack of an electromagnetic-wave reflecting part made of a conductive material and a film constituting part made of resin.

Next, a relationship between the aperture ratio and the surface electric resistance of the electromagnetic-wave shielding layer was simulated.

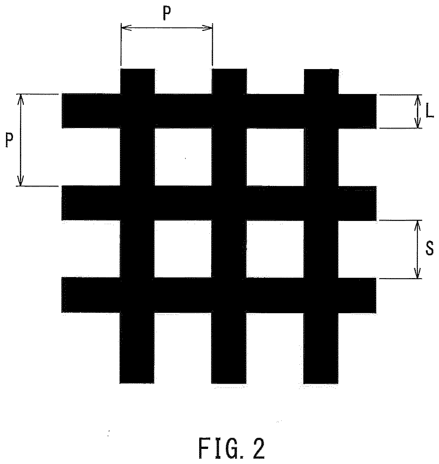

FIG. 2 is a model figure illustrating the shape of the electromagnetic-wave shielding layer used for the examination.

As illustrated in FIG. 2, it was assumed that the electromagnetic-wave shielding layer was a grid metal mesh in which metal wires extend in vertical and horizontal directions. A change in the aperture ratio in accordance with the change in a pitch P of the metal wires and the conductance as the metal layer were calculated, by taking one square constituted by the metal wires (conductive material) as an inductance element (coil) as a loop.

More specifically, it was assumed that metal wires 27 $\mu$m in diameter were used. The aperture ratio of the electromagnetic-wave shielding layer at this time is expressed by Formula (1) below, based on Pitch P = Wire diameter L + Space S between wires.

[Numerical Formula 1]

$$Aperture\ ratio\ = \frac{S^2}{(S+L)^2} * 100 \qquad (1)$$

When the attenuation amount of electromagnetic waves incident upon the platy electromagnetic-wave shielding layer is expressed in dB as a shielding SE, it is expressed by Formula (2) below, where $Z_0$ represents the input and out impedance of the metal plate, $\sigma(\Omega^{-1} \cdot m^{-1})$ represents the conductance of the metal plate, and d(m) represents the plate thickness.

[Numerical Formula 2]

$$SE = 20log \left| \frac{2 + Z_0 \sigma d}{2} \right| \qquad (2)$$

Here, when each square of the metal mesh is regarded as a coil, and the resistance R = 1/($\sigma \cdot$d) as the metal plate is replaced with j$\omega$L, the above Formula (2) can be converted to Formula (3) below.

[Numerical Formula 3]

$$SE = 20log \left| \frac{2 + \left( \frac{Z_0}{j\omega L} \right)}{2} \right|$$

$$= 20log \left| \frac{\sqrt{1 + \left( \frac{2\omega L}{Z_0} \right)^2}}{\left( \frac{2\omega L}{Z_0} \right)} \right| \qquad (3)$$

Since $\omega$ is 2nL ($\omega$ = 2nL), the electromagnetic-waves shielding SE can be expressed by Formula (4) below.
[Numerical Formula 4]

$$SE = 20log \left| \frac{\sqrt{1 + \left( \frac{4\pi f \cdot L}{Z_0} \right)^2}}{4\pi f \left( \frac{L}{Z_0} \right)} \right| \qquad (4)$$

The aperture ratio (Formula (1)) and the shielding SE (Formula (4)) were measured by changing the pitch P of the wires constituting the metal mesh. Table 1 indicates the results.

[TABLE 1]

| Frequency | 60-90 GHz | | |
|---|---|---|---|
| Pitch P of metal wires | 250 $\mu$m | 170 $\mu$m | 50 $\mu$m |
| Aperture ratio | 85% | 75% | 35% |
| Transmittance | **% | 60% | 30% |
| Shielding SE | 20.2 dB | 21.2 dB | 45.0 dB |

As indicated in Table 1, when the frequency of electromagnetic waves was 60 to 90 GHz, and the pitch (P) of the metal wires constituting the conductive mesh was 250 $\mu$m, the shielding SE of 20 dB, which corresponds to the attenuation amount of 99% could be achieved (20.2 dB). At this time, the aperture ratio of the conductive mesh was 85%, and the total light transmittance of the conductive mesh considering the bending of the metal wires was 66%. As described above, in the electromagnetic-wave absorbing sheet of this embodiment, an optically clear adhesive (OCA) film having a high transmittance can be used as the dielectric layer, and the transmittance of the electromagnetic-wave shielding layer is almost the same as the transmittance of the electromagnetic-wave absorbing sheet.

When the pitch P of the metal wires constituting the conductive mesh was 170 $\mu$m, the aperture ratio was 75%, the total light transmittance was 60%, and the shielding SE was 21.2 dB. In order to obtain an electromagnetic-wave absorbing sheet having light transmittance, it is considered that the electromagnetic-wave shielding layer needs to have a total light transmittance of about 30% or more. The pitch P of the metal wires to achieve this was 50 $\mu$m, and the aperture ratio at this time was 35% and the shielding SE indicating the electromagnetic-wave attenuation amount was 45.0 dB.

The above examination results of the electromagnetic-wave shielding effects in the electromagnetic-wave shielding layer 3 and the optical characteristics of the electromagnetic-wave shielding layer 3 indicate that the aperture ratio of 35% to 85% is a preferable condition in the case of using a conductive mesh or a conductive grid. Moreover, it is judged that the surface electric resistance is preferably 0.3 $\Omega$/sq or less in order for the electromagnetic-wave shielding layer 3 to obtain favorable electromagnetic-wave reflecting properties.

[Adhesive layer]

By providing the adhesive layer 4 in the electromagnetic-wave absorbing sheet of this embodiment, the electromagnetic-wave absorbing sheet as a stack of the electric resistance film 1, the dielectric layer 2 and the electromagnetic-wave shielding layer 3 can be attached to a desired position such as an inner surface of a housing that contains an electric circuit, or an inner surface or outer surface of an electric device. Specifically, since the electromagnetic-wave absorbing sheet of this embodiment has flexibility, it can be attached easily on a curved surface (bent surface). Thus, the adhesive layer 4 provided on the back surface of the sheet improves the handleability of the electromagnetic-wave absorbing sheet.

The adhesive layer 4 may be formed of a known material generally used as an adhesive layer such as an adhesive tape, and specific examples of which include an acrylic-based adhesive, a rubber-based adhesive, and a silicone-based adhesive. A tackifier or crosslinking agent may be used to adjust the adhesion with respect to an adherend and to reduce adhesive residues. The adhesive strength with respect to an adherend is preferably 5 N/10 mm to 12 N/10 mm as a measurement result by a 180° peel adhesion test method. If the adhesive strength is smaller than 5 N/10 mm, the electromagnetic-wave absorbing sheet may be easily peeled off or displaced from an adherend. If the adhesive strength is larger than 12 N/10 mm, the electromagnetic-wave absorbing sheet is difficult to be peeled off from an adherend.

The thickness of the adhesive layer 4 is preferably 20 $\mu$m to 100 $\mu$m. If the adhesive layer 4 is thinner than 20 pm, the adhesion is low and the electromagnetic-wave absorbing sheet may be easily peeled off or displaced from an adherend. If the adhesive layer 4 is thicker than 100 pm, the electromagnetic-wave absorbing sheet is difficult to be peeled off from an adherend. If the cohesion of the adhesive layer is low, an adhesive may remain on an adherend when the electromagnetic-wave absorbing sheet is peeled off from the adherend, and the flexibility of the electromagnetic-wave absorbing sheet as a whole may decrease.

The adhesive layer 4 to be used in the electromagnetic-wave absorbing sheet of this embodiment may be an adhesive layer 4 that makes the electromagnetic-wave absorbing sheet unpeelably attached to an adherend, or an adhesive layer 4 that makes the electromagnetic-wave absorbing sheet peelably attached to an adherend. Further, as described above, the adhesive layer 4 is not essential in the electromagnetic-wave absorbing sheet of this embodiment, and various conventional adhesion methods can be adopted to attach the electromagnetic-wave absorbing sheet to a desired member.

[Protective layer]

In the electromagnetic-wave absorbing sheet of this embodiment, the protective layer 5 may be provided on a surface of the electric resistance film 1 on the electromagnetic-wave incident side.

In the electromagnetic-wave absorbing sheet of this embodiment, the surface electric resistance of the conductive organic polymer used as the electric resistance film 1 may change due to humidity in the air. By providing the protective layer 5 on the surface of the electric resistance film 1, the influence of humidity can be reduced, and the electromagnetic-wave absorbing properties obtained by impedance matching can be effectively prevented from deteriorating.

In one example, the protective layer 5 in the electromagnetic-wave absorbing sheet of this embodiment can be polyethylene terephthalate having a thickness of 25 pm, which is attached on the surface of the electric resistance film 1 using an adhesive of a resin material.

By configuring the protective layer 5 to cover the entire surface of the electric resistance film 1, it is possible to prevent the influence of moisture in the air on the electric resistance film 1. It is considered that the surface electric resistance of the protective layer 5 formed as a resin film may affect the surface electric resistance of the electric resistance film 1 as a member connected in parallel with the electric resistance film 1. Because of this, if the protective layer 5 is not too thick, the influence given to the input impedance of the electromagnetic-wave absorbing sheet will be very little. It is also possible to set the surface electric resistance of the electric resistance film 1 to a more suitable value by taking into consideration the influence of the surface electric resistance of the protective layer 5 as the input impedance of the electromagnetic-wave absorbing sheet.

It is preferred that the thickness of the protective layer 5 is as thin as possible within a range that can protect the electric resistance film 1. Specifically, the thickness of the protective layer 5 is preferably 150 $\mu$m or less, and more preferably 100 $\mu$m or less. If the thickness of the protective layer exceeds 150 $\mu$m, electromagnetic-wave absorbency may decrease and the electromagnetic-wave absorption amount may be lower than 20 dB, and the thickness of the electromagnetic-wave absorbing sheet as a whole increases and the flexibility decreases.

[Examples]

Electromagnetic-wave absorbing sheets of this embodiment were actually produced to measure various properties. The following describes the results.

<Production of electromagnetic-wave absorbing sheets>

Materials described below were used to produce, as the electromagnetic-wave absorbing sheets of this embodiment, electromagnetic-wave absorbing sheets (sheets 1, 4, and 5) in which a silicone-based OCA was used as a dielectric layer, an electromagnetic-wave absorbing sheet (sheet 2) in which an acrylic-based OCA was used as a dielectric layer, and an electromagnetic-wave absorbing sheet (sheet 3) in which a urethane-based OCA was used as a dielectric layer. Moreover, as a comparative example, an electromagnetic-wave absorbing sheet (Comparative Example 1) in which PET was used as a dielectric layer was produced.

[Electric resistance film]

An electric resistance film liquid was prepared by adding and mixing the following components.

| | |
|---|---|
| (1) Conductive polymer dispersing element (PEDOT-PSS) (PH-1000 (trade name) manufactured by Heraeus Holding), Solid content concentration: 1.2 mass % | 36.7 parts |
| (2) PVDF dispersion LATEX 32 (trade name) manufactured by Arkema S.A, Solid content concentration: 20 mass %, Solvent: Water | 5.6 parts |
| (3) Water-soluble polyester aqueous solution PLAS COAT Z561 (trade name) manufactured by GOO CHEMICAL CO., LTD., Solid content concentration: 25 mass % | 0.6 parts |
| (4) Organic solvent (dimethylsulfoxide) | 9.9 parts |
| (5) Water-soluble solvent (ethanol) | 30.0 parts |
| (6) Water | 17.2 parts |

Each of electric resistance films of the electromagnetic-wave absorbing sheets of the examples (sheets 1-5) and an electric resistance film of the electromagnetic-wave absorbing sheet of the comparative example were formed by applying the electric resistance film liquid in the proportion described above onto a polyethylene terephthalate sheet (50 $\mu$m thick, base) by bar coating, in an amount so that the thickness after drying would be about 120 nm, and the applied liquid was heated at 150°C for five minutes. The surface electric resistances of the electric resistance films thus produced were all 377 $\Omega$/sq.

[Dielectric layer]

As the dielectric layers of the electromagnetic-wave absorbing sheets of the examples, the following materials were used. Moreover, the electromagnetic-wave absorbing sheet of Comparative Example 1 was produced using polyethylene terephthalate (PET) resin as below in the same manner as the sheet 1 except for the dielectric layer.

- Silicone-based OCA

NEHM-SI-500 (trade name) manufactured by Nichiei Kakoh Co., Ltd.
Thickness 500: $\mu$m, Adhesive strength: 10 N/25 mm, Permittivity: 3.0

- Acrylic-based OCA

MHM-FWV (trade name) manufactured by Nichiei Kakoh Co., Ltd.

Thickness: 500 pm, Adhesive strength: 30 N/25 mm, Permittivity: 3.5

- Urethane-based OCA

Free Crystal (trade name) manufactured by Bando Chemical Industries, Ltd.
Thickness: 500 pm, Adhesive strength: 25 N/25 mm, Permittivity: 2.3

- Comparative Example 1

PET: U32 (trade name) manufactured by Toray Industries, Inc.
Thickness: 500 $\mu$m (250 $\mu$m + 250 $\mu$m)

[Electromagnetic-wave shielding layer]

Electromagnetic-wave shielding layers 1 of the sheets 1-3 were formed using a conductive mesh Su-4X-13227 (trade name, aperture ratio of 75%) manufactured by SEIREN Co., Ltd. In order to check the change in properties due to the difference in the aperture ratio of conductive meshes, a conductive mesh Su-4X-9027 (trade name, aperture ratio of 82%) manufactured by SEIREN Co., Ltd was used as an electromagnetic-wave shielding layer 2 of the sheet 4 in which the silicone-based OCA was used as the dielectric layer. Further, a conductive mesh Su-4X-27036 (trade name, aperture ratio of 38%) manufactured by SEIREN Co., Ltd was used as an electromagnetic-wave shielding layer 3 of the sheet 5.
The electromagnetic-wave shielding layer 1 having an aperture ratio of 75% described above was used as the electromagnetic-wave shielding layer of the electromagnetic-wave absorbing sheet of the comparative example.

[Formation of sheet]

Each of the electromagnetic-wave absorbing sheets 1-5 of the examples described above was formed by first attaching the electric resistance film to the dielectric layer using the adhesion of the dielectric layer, and then attaching the conductive mesh as the electromagnetic-wave shielding layer to a surface of the dielectric layer on a side opposite to the surface to which the electric resistance film was attached. The electromagnetic-wave absorbing sheet of the comparative example in which PET was used as the dielectric layer was formed by attaching the electric resistance film and the electromagnetic-wave shielding layer to the dielectric layer using an acrylic-based OCA having a thickness of 20 $\mu$m.

[Measurement method]

The total light transmittance and the haze value of each of the electromagnetic-wave absorbing sheets of the examples (sheets 1-5) and the electromagnetic-wave absorbing sheet of the comparative example produced as above were measured.
The total light transmittance and the haze value were measured using a Haze Meter NDH2000 (trade name) manufactured by NIPPON DENSHOKU INDUSTRIES Co., Ltd., in accordance with JIS K7105. A Light C was used as a light source.
The electromagnetic-wave absorbing properties were measured in accordance with a free space method. Specifically, a free space measuring device manufactured by KEYCOM Corporation and a vector network analyzer MS4647 B (trade name) manufactured by ANRITSU CORPORATION were used to determine, as a voltage, a ratio between the intensity of incident waves and the intensity of reflected waves at the time of irradiating each of the electromagnetic-wave absorbing sheets with electromagnetic waves.
Table 2 indicates the measurement results.

[TABLE 2]

|  | Sheet 1* | Sheet 2 | Sheet 3 | Sheet 4* | Sheet 5* |
| --- | --- | --- | --- | --- | --- |
| Dielectric layer |  |  |  |  |  |

13

(continued)

|  | | Sheet 1* | Sheet 2 | Sheet 3 | Sheet 4* | Sheet 5* |
|---|---|---|---|---|---|---|
|  | Material | Silicone-based OCA | Acrylic-based OCA | Urethane-based OCA | Silicone-based OCA | Silicone-based OCA |
|  | Thickness [$\mu$m] | 500 | 500 | 500 | 500 | 500 |
|  | Adhesive strength [N/25 mm] | 10 | 30 | 25 | 10 | 10 |
|  | Permittivity | 3 | 3.5 | 2.3 | 3 | 3 |
| Electromagnetic-wave shielding layer | | Shielding layer 1 | Shielding layer 1 | Shielding layer 1 | Shielding layer 2 | Shielding layer 3 |
|  | Aperture ratio [%] | 75 | 75 | 75 | 82 | 38 |
|  | Pitch of wires [$\mu$m] | 170 | 170 | 170 | 250 | 57 |
| Transmittance of sheet [%] | | 66.2 | 66.3 | 66.1 | 66 | 30 |
| Haze value | | 12 | 12 | 12 | 7 | 40 |
| *: Non-claimed example | | | | | | |

As indicated in Table 2, regarding the electromagnetic-wave absorbing sheets in which the conductive mesh having an aperture ratio of 75% was used as the electromagnetic-wave shielding layer, the electromagnetic-wave absorbing sheet 1 in which the silicone-based OCA was used as the dielectric layer had a total light transmittance of 60% and a haze value of 12; the electromagnetic-wave absorbing sheet 2 in which the acrylic-based OCA was used as the dielectric layer had a total light transmittance of 60% and a haze value of 12; and the electromagnetic-wave absorbing sheet 3 in which the urethane-based OCA was used as the dielectric layer had a total light transmittance of 60% and a haze value of 12.

Meanwhile, the electromagnetic-wave absorbing sheet of the comparative example in which the same conductive mesh having an aperture ratio of 75% was used as the electromagnetic-wave shielding layer and PET was used as the dielectric layer had a total light transmittance of 59.9% and a haze value of 21. Therefore, it was confirmed that the optical characteristics of all of the electromagnetic-wave absorbing sheets of the examples were superior to the optical characteristics of the electromagnetic-wave absorbing sheet of the comparative example. Herein, Sheet 1, Sheet 4 and Sheet 5 are non-claimed examples.

Moreover, the electromagnetic-wave absorbing sheet 4 in which the conductive mesh having an aperture ratio of 82% was used as the electromagnetic-wave shielding layer and the silicone-based OCA was used as the dielectric layer had a total light transmittance of 66% and a haze value of 7. It was confirmed that when the aperture ratio of the conductive mesh was increased from 75% to 82%, the total light transmittance and the haze value improved, and an electromagnetic-wave absorbing sheet that can obtain a transmitted-light image with less distortion and less blur could be produced. On the other hand, the electromagnetic-wave absorbing sheet 5 in which the conductive mesh having an aperture ratio of 38% was used as the electromagnetic-wave shielding layer and the silicone-based OCA was used as the dielectric layer had a total light transmittance of 30% and a haze value of 40, and a high value could be obtained as electromagnetic-wave absorbing properties, but the characteristics are within an allowable range from the viewpoint of the light transmittance.

From these measurement results, in order for the electromagnetic-wave absorbing sheet of this embodiment to be an electromagnetic-wave absorbing sheet having light transmittance, the sheet as a whole preferably has light transmittance having a total light transmittance of 30% or more. Moreover, the surface electric resistance of the electromagnetic-wave shielding layer constituted by the conductive mesh is preferably 0.3 $\Omega$/sq or less. Further, the aperture ratio of the conductive mesh is preferably 35% to 85%, and more preferably 38% to 82% based on the examples.

[Confirmation of flexibility]

Next, the flexibility of the electromagnetic-wave absorbing sheet of this embodiment was confirmed.

The electromagnetic-wave absorbing sheets 1-5 produced above were each cut into a size of 5 x 10 cm, and their initial surface electric resistances were measured and confirmed to be 377 $\Omega$.

Next, the sheets were placed on horizontally arranged six aluminum cylindrical rods (mandrels) 10 mm, 8 mm, 6 mm, 4 mm, 2 mm, and 0.5 mm in diameter so that the electric resistance films would face upward. A weight of 300 g was attached to both ends of the sheets, and this state was maintained for 30 seconds. The both ends of the sheets were pulled downward with the center of the sheets being bent. Then, the surface electric resistances of the electromagnetic-wave absorbing sheets were measured.

As a result, the surface electric resistances (377 SZ) of the electric resistance films of all of the electromagnetic-wave absorbing sheets 1-5 described above did not change. A surface of each sheet was observed using a microscope at 100x magnification, and it was confirmed that no crack or the like appeared on the surface.

On the other hand, in confirming flexibility, an electromagnetic-wave absorbing sheet of a comparative example (a sheet of Comparative Example 2) was produced in the same manner as the sheet 1 except that an electric resistance film was formed of a transparent conductive film (ITO), and the flexibility of the electromagnetic-wave absorbing sheet was confirmed under the same conditions as above. In the case of the aluminum cylindrical rod 10 mm in diameter, no change in the surface electric resistance of the sheet was observed. In the case of the aluminum cylindrical rod 6 mm in diameter, the surface electric resistance increased to 750 $\Omega$/sq, which is about twice the initial surface electric resistance. In the cases of the aluminum cylindrical rods 2 mm and 0.5 mm in diameter, the surface electric resistance became infinite, and the film could no longer be used as the electric resistance film.

On the basis of the above result, regarding the flexibility of the electromagnetic-wave absorbing sheet disclosed in this application, in the above-described flexibility test in which the aluminum cylindrical rods are used, the change in the surface electric resistance after the completion of the test is preferably less than twice the initial surface electric resistance, and more preferably 1.5 times or less than the initial surface electric resistance.

Moreover, in confirming flexibility, in the case of the comparative example in which the electric resistance film was formed of the transparent conductive film (ITO), it was confirmed that cracks appeared on a surface of the electromagnetic-wave absorbing sheet wounded around the aluminum cylindrical rod 6 mm in diameter, and that more cracks appeared on a surface of the electromagnetic-wave absorbing sheet wounded around the aluminum cylindrical rod 0.5 mm in diameter.

The above result confirmed that, by using the conductive organic polymer as the electric resistance film in the electromagnetic-wave absorbing sheet of this embodiment, the flexibility of the sheet improves and the electromagnetic-wave absorbing properties can be maintained even when a load that causes the sheet to strongly bend with a small diameter, is applied to the sheet.

As described above, in the electromagnetic-wave absorbing sheet of this embodiment, by constituting the electric resistance film 1 to be arranged on the surface on the electromagnetic-wave incident side using the conductive organic polymer, electromagnetic-wave absorbing properties can be maintained even when the electromagnetic-wave absorbing sheet is strongly bent. Moreover, by constituting all of the electric resistance film 1, the dielectric layer 2, and the electromagnetic-wave shielding layer 3 using materials having light transmittance, an electromagnetic-wave absorbing sheet having light transmittance in addition to flexibility can be obtained. For example, the electromagnetic-wave absorbing sheet can be suitably used in a situation in which it is necessary to absorb undesired electromagnetic waves to avoid transmission of undesired electromagnetic waves while allowing a user to observe the conditions inside or outside the sheet, such as a curtain to create an electromagnetic-wave shielded room.

Further, by the dielectric layer 2 having adhesiveness, the electric resistance film 1 and the dielectric layer 2 as well as the dielectric layer 2 and the electromagnetic-wave shielding layer 3 can easily adhere to each other. Therefore, when the electric resistance film 1 is the conductive polymer, and the electromagnetic-wave shielding layer 3 is the conductive mesh or the conductive grid, a special adhesion step such as a lamination step that has conventionally been necessary for the adhesion to the dielectric layer can be eliminated, thereby reducing the production costs of the electromagnetic-wave absorbing sheet.

(Other configuration examples not forming part of the invention)

The above embodiment exemplifies the electromagnetic-wave absorbing sheets that have light transmittance having a total light transmittance of 30% or more as a whole. However, the electromagnetic-wave absorbing sheet disclosed in this application does not always need to have light transmittance.

If the sheet is not required to have light transmittance, it is possible to form an electromagnetic-wave absorbing sheet using an electric resistance film, a dielectric layer, and an electromagnetic-wave shielding layer of materials having no light transmittance. In this case, by a dielectric layer having adhesiveness, it is possible to constitute an electromagnetic-wave absorbing sheet of an electromagnetic-wave interference type having flexibility and being capable of absorbing electromagnetic waves of high frequencies equal to or higher than the millimeter-wave band at low cost.

If the electromagnetic-wave absorbing sheet does not need to have light transmittance, there is a larger choice of materials such as a conductive organic polymer material for constituting the electric resistance film and a dopant to be added appropriately. Moreover, it is possible to select, as a material forming the dielectric layer, a material in which a dielectric material such as titanium oxide, polyvinylidene fluoride, polyester resin, glass, silicone rubber or the like is mixed with one of various materials having adhesiveness.

Further, in non-claimed examples the electromagnetic-wave shielding layer does not need to be in a form that has light transmittance such as a mesh or a grid, and may be a reflective sheet formed by evaporating and depositing metal on a surface of a metal foil or a resin base as long as the flexibility of the electric resistance film or the dielectric layer is not impaired. In this case, by using the adhesiveness of the dielectric layer, a metal foil or a metal-deposited film can be attached to the back side of the dielectric layer so that no space is formed between the dielectric layer and the electromagnetic-wave shielding layer.

Industrial Applicability

The electromagnetic-wave absorbing sheet disclosed in this application is useful as a low-cost electromagnetic-wave absorbing sheet that can stably absorb electromagnetic waves in a high frequency band equal to or higher than the millimeter-wave band and has flexibility.

Description of Reference Numerals

1    electric resistance film
2    dielectric layer
3    electromagnetic-wave shielding layer
4    adhesive layer
5    protective layer

**Claims**

1.  An electromagnetic-wave absorbing sheet of an electromagnetic-wave interference type, comprising:

    an electric resistance film (1) formed of a conductive organic polymer, the electric resistance film (1) having light transmittance;
    a dielectric layer (2) comprising an optically clear adhesive film, the dielectric layer (2) having adhesiveness and light transmittance; and
    an electromagnetic-wave shielding layer (3) being a conductive mesh, the electromagnetic-wave shielding layer (3) having an aperture ratio of 35% to 85%,
    the electric resistance film (1), the dielectric layer (2), and the electromagnetic-wave shielding layer (3) being sequentially stacked,
    the sheet as a whole having flexibility,
    a thickness of the dielectric layer (2) being set so that the dielectric layer absorbs electromagnetic waves in a frequency band equal to or higher than a millimeter-wave band, and
    the sheet as a whole having a total light transmittance of 30% or more,
    wherein the dielectric layer (2) is selected from the group consisting of an acrylic-based optically clear adhesive film and a urethane-based optically clear adhesive film.

2.  The electromagnetic-wave absorbing sheet according to claim 1, wherein the electromagnetic-wave shielding layer (3) has a surface electric resistance of 0.3 $\Omega$/sq or less.

3.  The electromagnetic-wave absorbing sheet according to claim 1 or 2, wherein the electric resistance film (1) comprises poly(3,4-ethylenedioxythiophene).

4.  The electromagnetic-wave absorbing sheet according to any of claims 1 to 3, further comprising an adhesive layer (4) on a surface of the electromagnetic-wave shielding layer (3) on a side opposite to a side where the dielectric layer (2) is disposed.

**Patentansprüche**

1.  Elektromagnetische Wellen absorbierende Folie vom Elektromagnetische-Wellen-Interferenz-Typ, mit:

einem aus einem leitfähigen organischen Polymer gebildeten Elektrischer-Widerstands-Film (1), wobei der Elektrischer-Widerstands-Film (1) Lichtdurchlässigkeit aufweist;

einer dielektrischen Schicht (2) mit einem optisch klaren Klebstofffilm, wobei die dielektrische Schicht (2) Klebrigkeit und Lichtdurchlässigkeit aufweist; und

einer Elektromagnetische-Wellen-Abschirmschicht (3), die ein leitfähiges Netz ist, wobei die Elektromagnetische-Wellen-Abschirmschicht (3) einen Aperturanteil von 35 % bis 85 % aufweist,

wobei der Elektrischer-Widerstands-Film (1), die dielektrische Schicht (2) und die Elektromagnetische-Wellen-Abschirmschicht (3) sequenziell gestapelt sind, die Folie als Ganzes Flexibilität aufweist,

eine Dicke der dielektrischen Schicht (2) derart eingestellt ist, dass die dielektrische Schicht elektromagnetische Wellen in einem Frequenzband gleich oder höher als ein Millimeterwellenband absorbiert, und

die Folie als Ganzes eine Gesamt-Lichtdurchlässigkeit von 30 % oder mehr aufweist,

wobei die dielektrische Schicht (2) ausgewählt ist aus der Gruppe, die aus einem Acryl-basierten optisch klaren Klebstofffilm und einem Urethan-basierten optisch klaren Klebstofffilm.

2. Elektromagnetische Wellen absorbierende Folie gemäß Anspruch 1, wobei die Elektromagnetische-Wellen-Abschirmschicht (3) einen elektrischen Oberflächenwiderstand von 0,3 $\Omega/\square$ oder weniger aufweist.

3. Elektromagnetische Wellen absorbierende Folie gemäß Anspruch 1 oder 2, wobei der Elektrischer-Widerstands-Film (1) Poly(3,4-ethylendioxythiophen) beinhaltet.

4. Elektromagnetische Wellen absorbierende Folie gemäß einem der Ansprüche 1 bis 3, ferner aufweisend eine Klebstoffschicht (4) auf einer Oberfläche der Elektromagnetische-Wellen-Abschirmschicht (3) auf einer Seite gegenüber derjenigen Seite, auf der die dielektrische Schicht (2) angeordnet ist.

**Revendications**

1. Feuille absorbant les ondes électromagnétiques d'un type d'interférence d'ondes électromagnétiques, comprenant :

un film à résistance électrique (1) formé d'un polymère organique conducteur, le film à résistance électrique (1) ayant une transmission de la lumière ;

une couche diélectrique (2) comprenant un film adhésif optiquement clair, la couche diélectrique (2) ayant une capacité d'adhésion et de transmission de lumière ; et

une couche de protection contre les ondes électromagnétiques (3) étant un treillis conducteur, la couche de protection contre les ondes électromagnétiques (3) ayant un rapport d'ouverture de 35 % à 85 %,

le film de résistance électrique (1), la couche diélectrique (2) et la couche de protection contre les ondes électromagnétiques (3) étant empilés de manière séquentielle,

la feuille dans son ensemble ayant de la flexibilité,

l'épaisseur de la couche diélectrique (2) étant réglée de manière à ce que la couche diélectrique absorbe les ondes électromagnétiques dans une bande de fréquence égale ou supérieure à une bande d'ondes millimétriques, et

la feuille dans son ensemble ayant une transmission totale de la lumière de 30 % ou plus, dans laquelle la couche diélectrique (2) est choisie dans le groupe constitué d'un film adhésif optiquement clair à base d'acrylique et d'un film adhésif optiquement clair à base d'uréthane.

2. Feuille absorbant les ondes électromagnétiques selon la revendication 1, dans laquelle la couche de protection contre les ondes électromagnétiques (3) a une résistance électrique de surface de 0,3 $\Omega/sq$ ou moins.

3. Feuille d'absorption d'onde électromagnétique selon la revendication 1 ou 2, dans laquelle le film de résistance électrique (1) comprend du poly(3,4-éthylènedioxythiophène).

4. Feuille absorbant les ondes électromagnétiques selon l'une quelconque des revendications 1 à 3, comprenant en outre une couche adhésive (4) sur une surface de la couche de protection contre les ondes électromagnétiques (3) sur un côté opposé à un côté où la couche diélectrique (2) est disposée.

FIG. 1

FIG. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H061994120689 A
- JP H091997232787 A
- JP 2006086446 A
- WO 2018088492 A1